(19) Europäisches Patentamt
European Patent Office
Office européen des brevets

(11) **EP 4 343 358 A1**

(12) **EUROPEAN PATENT APPLICATION**
published in accordance with Art. 153(4) EPC

(43) Date of publication:
**27.03.2024  Bulletin 2024/13**

(51) International Patent Classification (IPC):
**G01R 33/565** [(2006.01)]

(21) Application number: **23769835.2**

(86) International application number:
**PCT/CN2023/081635**

(22) Date of filing: **15.03.2023**

(87) International publication number:
**WO 2023/174333 (21.09.2023 Gazette 2023/38)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **15.03.2022  CN 202210253003**

(71) Applicant: **Wuhan United Imaging Life Science
Instrument Co., Ltd
Wuhan, Hubei 430206 (CN)**

(72) Inventors:
• **JI, Meiling
Wuhan, Hubei 430206 (CN)**
• **ZHAI, Renkuan
Wuhan, Hubei 430206 (CN)**

(74) Representative: **Murgitroyd & Company
165-169 Scotland Street
Glasgow G5 8PL (GB)**

(54) **METHOD FOR DETERMINING MAGNETIC RESONANCE GRADIENT CORRECTION COMPENSATION FACTOR, MAGNETIC RESONANCE GRADIENT CORRECTION METHOD, AND APPARATUS**

(57)    A method for determining a magnetic resonance gradient correction compensation factors, comprising: obtaining axial magnetic resonance signals when a mold applies a diffusion gradient to a gradient coil in different axial directions and a reference magnetic resonance signal when no diffusion gradient is applied to the gradient coil (S202); determining diffusion coefficient calculation values of a liquid in different axial directions according to the axial magnetic resonance signals and the reference magnetic resonance signal (S204); and determining, according to the diffusion coefficient calculation values of the liquid in different axial directions and a reference diffusion coefficient, gradient correction compensation factors of corresponding axes (S206). The mold is a mold filled with the liquid, and the liquid is isotropic. Also disclosed are a magnetic resonance gradient correction method and an apparatus.

EP 4 343 358 A1

Acquire axis direction magnetic resonance signals of a phantom for respective axis directions when diffusion gradient is applied to a gradient coil in each of the axis directions, and acquiring a reference magnetic resonance signal when no diffusion gradient is applied to the gradient coil — S202

Determine, based on the reference magnetic resonance signal and each of axis direction magnetic resonance signals, a diffusion coefficient calculation value for the liquid in each of the axis directions — S204

Determine, based on the diffusion coefficient calculation value for the liquid in each of the axis directions and a reference diffusion coefficient of the liquid, a gradient correction compensation factor for the respective axis direction — S206

FIG. 3

## Description

**CROSS-REFERENCE** TO RELATED APPLICATIONS

The present application claims priority to Chinese patent application No. 202210253003.0, filed on March 15, 2022, and entitled "METHOD FOR DETERMINING MAGNETIC RESONANCE GRADIENT CORRECTION COMPENSATION FACTOR, MAGNETIC RESONANCE GRADIENT CORRECTION METHOD, AND APPARATUS", the entire content of which is incorporated herein by reference.

TECHNICAL FIELD

The present disclosure relates to the field of magnetic resonance equipment, and more particularly, to a method for determining a magnetic resonance gradient correction compensation factor, a magnetic resonance gradient correction method, and apparatus.

## BACKGROUND

At present, magnetic resonance imaging is mainly performed by a magnetic resonance system. The magnetic resonance system generally includes a main magnet, a gradient coil, a radio frequency coil, an image reconstruction module, and other devices. The main magnet can generate a main magnetic field in an imaging space, the gradient coil can generate a gradient magnetic field in the imaging space, and the radio frequency coil can generate radio frequency pulses in the imaging space. The image reconstruction module mainly performs image reconstruction on the received magnetic resonance signal to obtain a magnetic resonance image.

In the actual magnetic resonance imaging process, it is usually necessary to correct the gradient magnetic field strength generated by the gradient coil, referred to as gradient correction, to ensure the accuracy of the actual gradient. In the related art, when the gradient magnetic field strength correction is performed, generally, a completely spherical water phantom is placed strictly at the center of the main magnet. After that, the water phantom is imaged, and data analysis including geometry analysis is performed on the acquired image of the water phantom, to obtain corrected parameters for correcting the gradient magnetic field strength.

However, the above technology has very strict requirements on the geometry and position of the water phantom, but it is difficult to guarantee such high accuracy in the actual imaging process. As a result, the obtained image of the water phantom is not accurate enough, and the obtained corrected parameters are also not accurate enough, making it difficult to ensure the accuracy of the gradient correction.

## SUMMARY

In view of the above technical problems, it is necessary to provide a method for determining a magnetic resonance gradient correction compensation factor, a magnetic resonance gradient correction method and device, a magnetic resonance system, a computer-readable storage medium, and a computer program product, which can improve the accuracy of the corrected parameters and improve the efficiency of the gradient correction process.

In a first aspect, the present disclosure provides a method for determining a magnetic resonance gradient correction compensation factor. The method includes:

acquiring axis direction magnetic resonance signals of a phantom for respective axis directions when diffusion gradient is applied to a gradient coil in each of the axis directions, and acquiring a reference magnetic resonance signal when no diffusion gradient is applied to the gradient coil, the phantom being filled with liquid, and the liquid being isotropic;

determining, based on the reference magnetic resonance signal and each of axis direction magnetic resonance signals, a diffusion coefficient calculation value for the liquid in each of the axis directions; and

determining, based on the diffusion coefficient calculation value for the liquid in each of the axis directions and a reference diffusion coefficient of the liquid, a gradient correction compensation factor for the respective axis direction.

In an embodiment, the reference diffusion coefficient is an intrinsic diffusion coefficient of the liquid.

In an embodiment, the diffusion gradient applied to the gradient coil acts in orthogonal x, y, and z axis directions, respectively.

In an embodiment, the phantom is placed in a magnet at any position where the gradient keeps linearity.

In an embodiment, the determining, based on the diffusion coefficient calculation value for the liquid in each of the axis directions and the reference diffusion coefficient, the gradient correction compensation factor for the respective axis direction includes:

calculating the gradient correction compensation factor for the respective axis direction according to a formula of $k_i = \sqrt{D_i/D_0}$,

where i refers to the respective axis direction, $k_i$ refers to the gradient correction compensation factor for the respective axis direction, $D_i$ refers to the diffusion coefficient calculation value in the respective axis direction, and $D_0$ refers to the reference diffusion coefficient.

In a second aspect, the present disclosure also provides a magnetic resonance gradient correction method. The method includes correcting a gradient of the gradient coil in the respective axis direction using the gradient correction compensation factor for the respective axis direction according to the first aspect.

In a third aspect, the present disclosure also provides a device for determining a magnetic resonance gradient correction compensation factor. The device includes:

a signal acquisition module configured to acquire axis direction magnetic resonance signals of a phantom for respective axis directions when diffusion gradient is applied to a gradient coil in each of the axis directions, and acquire a reference magnetic resonance signal when no diffusion gradient is applied to the gradient coil, wherein the phantom is filled with liquid, and the liquid is isotropic;

a coefficient determination module configured to determine, based on the reference magnetic resonance signal and each of axis direction magnetic resonance signals, a diffusion coefficient calculation value for the liquid in each of the axis directions; and

a compensation factor determination module configured to determine, based on the diffusion coefficient calculation value for the liquid in each of the axis directions and a reference diffusion coefficient of the liquid, a gradient correction compensation factor for the respective axis direction.

In a fourth aspect, the present disclosure also provides a magnetic resonance gradient correction device. The device includes:

a signal acquisition module configured to acquire axis direction magnetic resonance signals of the phantom for respective axis directions when applying diffusion gradients to a gradient coil in each of the axis directions, and acquire a reference magnetic resonance signal when no diffusion gradient is applied to the gradient coil, wherein the phantom is filled with liquid, and the liquid is isotropic;

a coefficient determination module configured to determine, based on the reference magnetic resonance signal and each of axis direction magnetic resonance signals, a diffusion coefficient calculation value for the liquid in each of the axis directions;

a compensation factor determination module configured to determine, based on the diffusion coefficient calculation value for the liquid in each of the axis directions and a reference diffusion coefficient of the liquid, a gradient correction compensation factor for the respective axis direction; and

a correction module configured to correct a gradient in the respective axis direction of the gradient coil using the gradient correction compensation factor for the respective axis direction.

In a fifth aspect, the present disclosure also provides a magnetic resonance system including a magnetic resonance scan apparatus and a computer apparatus connected to each other. The magnetic resonance scan apparatus includes a main magnet and gradient coils, the computer apparatus includes a memory and a processor, and the memory stores a computer program. The processor, when executing the computer program, implements the following steps:

acquiring axis direction magnetic resonance signals of a phantom for respective axis directions when diffusion gradient is applied to a gradient coil in each of the axis directions, and acquiring a reference magnetic resonance signal when no diffusion gradient is applied to the gradient coil, wherein the phantom is filled with liquid, and the liquid is isotropic;

determining, based on the reference magnetic resonance signal and each of axis direction magnetic resonance signals, a diffusion coefficient calculation value for the liquid in each of the axis directions; and

determining, based on the diffusion coefficient calculation value for the liquid in each of the axis directions and a reference diffusion coefficient of the liquid, a gradient correction compensation factor for the respective axis direction.

In a sixth aspect, the present disclosure also provides a computer apparatus. The computer apparatus includes a memory and a processor. The memory stores a computer program, and the processor, when executing the computer program, implements the following step: correcting a gradient in the respective axis direction of the gradient coil using the gradient correction compensation factor for the respective axis direction according to the first aspect.

In a seventh aspect, the present disclosure also provides a computer-readable storage medium having a computer program stored thereon. When the computer program is executed by a processor, the following steps are implemented:

acquiring axis direction magnetic resonance signals of a phantom for respective axis directions when diffusion gradient is applied to a gradient coil in each of the axis directions, and acquiring a reference magnetic resonance signal when no diffusion gradient is applied to the gradient coil, wherein the phantom is filled with liquid, and the liquid is isotropic;

determining, based on the reference magnetic resonance signal and each of axis direction magnetic resonance signals, a diffusion coefficient calculation value for the liquid in each of the axis directions; and

determining, based on the diffusion coefficient calculation value for the liquid in each of the axis directions and a reference diffusion coefficient of the liquid, a gradient correction compensation factor for the respective axis direction.

In an eighth aspect, the present disclosure also provides a computer-readable storage medium having a computer program stored thereon. When the computer program is executed by a processor, the following step is implemented:

correcting a gradient in the respective axis direction of the gradient coil using the gradient correction compensation factor for the respective axis direction according to the first aspect.

In a ninth aspect, the present disclosure also provides a computer program product. The computer program product includes a computer program. When the computer program is executed by a processor, the following steps are implemented:

acquiring axis direction magnetic resonance signals of a phantom for respective axis directions when diffusion gradient is applied to a gradient coil in each of the axis directions, and acquiring a reference magnetic resonance signal when no diffusion gradient is applied to the gradient coil, wherein the phantom is filled with liquid, and the liquid is isotropic; determining, based on the reference magnetic resonance signal and each of axis direction magnetic resonance signals, a diffusion coefficient calculation value for the liquid in each of the axis directions; and determining, based on the diffusion coefficient calculation value for the liquid in each of the axis directions and a reference diffusion coefficient of the liquid, a gradient correction compensation factor for the respective axis direction.

In a tenth aspect, the present disclosure also provides a computer program product. The computer program product includes a computer program. When the computer program is executed by a processor, the following step is implemented:

correcting a gradient in the respective axis direction of the gradient coil using the gradient correction compensation factor for the respective axis direction according to the first aspect.

With the above method for determining a magnetic resonance gradient correction compensation factor, a magnetic resonance gradient correction method and device, a magnetic resonance system, a computer-readable storage medium, and a computer program product, a diffusion coefficient calculation value for liquid in each of the axis directions is determined based on axis direction magnetic resonance signals of the phantom filled with isotropic liquid acquired when diffusion gradient is applied to a gradient coil, and a reference magnetic resonance signal acquired when no diffusion gradient is applied to the gradient coil. A gradient correction compensation factor for the respective axis direction is determined based on the diffusion coefficient calculation value for the liquid in each of the axis directions and a reference diffusion coefficient of the liquid. And then the gradient in the respective axis direction of the gradient coil is corrected using the gradient correction compensation factor for the respective axis direction. In this way, the diffusion coefficient calculation value for the liquid in each of the axis directions can be calculated using the diffusion property of the isotropic liquid, and the gradient correction compensation factor for the respective axis directions can be calculated based on the diffusion coefficient calculation value in the respective axis direction. The calculation of the gradient correction compensation factor does not involve the position and size of the phantom, that is, it is independent of the position and size of the phantom. As a result, the determined gradient correction compensation factor for each of the axis directions is more accurate. And when each gradient correction compensation factor is used for gradient correction, the accuracy of the obtained correction result can be also improved, that is, the accuracy of the gradient correction for each of the axis directions can be improved. In addition, since there is no need to specify the position and size of the phantom, it can save time for designing or positioning the phantom, simplify the gradient correction process, and thus improve the efficiency of the gradient correction process.

## BRIEF DESCRIPTION OF THE DRAWINGS

FIG. 1 is a schematic diagram illustrating an application environment of a magnetic resonance gradient correction method in an embodiment.
FIG. 2 is a schematic diagram illustrating an internal configuration of a computer apparatus in an embodiment.
FIG. 3 is a schematic flow diagram illustrating a method for determining a magnetic resonance gradient correction compensation factor in an embodiment.
FIG. 4 is a schematic flow diagram illustrating a magnetic resonance gradient correction method in an embodiment.
FIG. 5 is an example diagram illustrating a magnetic resonance gradient correction method in another embodiment.
FIG. 6 is a block diagram illustrating a configuration of a device for determining a magnetic resonance gradient correction compensation factor in an embodiment.
FIG. 7 is a block diagram illustrating a configuration of a magnetic resonance gradient correction device in an embodiment.

## DETAILED DESCRIPTION OF THE EMBODIMENTS

In order to make the above objectives, features, and advantages of the present disclosure more clear, specific implementations of the present disclosure are described in detail below with reference to the accompanying drawings. It should be understood that the specific embodiments described herein are merely intended to explain the present disclosure and are not intended to limit the present disclosure.

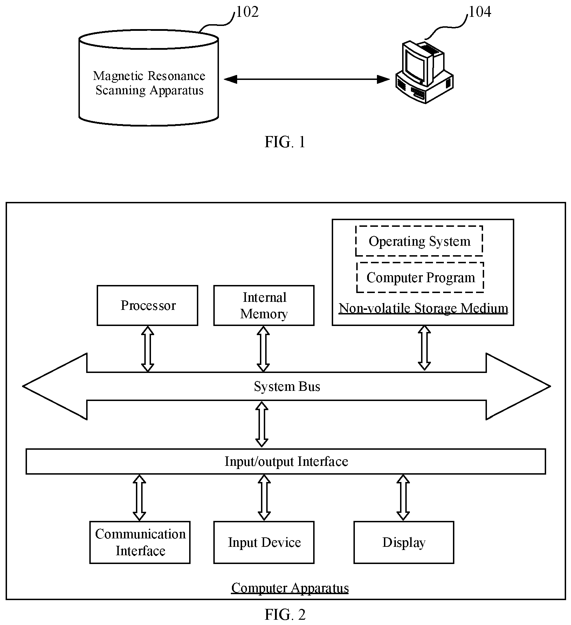

The method for determining a magnetic resonance gradient correction compensation factor, and the magnetic resonance gradient correction method provided in the embodiments of the present disclosure may be applied to the magnetic resonance system shown in FIG. 1. The magnetic resonance system includes a magnetic resonance scan apparatus 102 and a computer apparatus 104 connected to each other. The magnetic resonance scan apparatus 102 may include a main magnet and gradient coils, radio frequency coils and other devices. The main magnet may generate a main magnetic field in an imaging space, the gradient coil may generate a gradient magnetic field in the imaging space, and the radio frequency coil may generate radio frequency pulses in the imaging space. The computer apparatus may include an image reconstruction device, a gradient correction device, etc. The image reconstruction device mainly reconstructs a magnetic resonance image according to the received magnetic resonance signal. The gradient correction device mainly determines gradient correction compensation factors and corrects the gradient of the magnetic resonance system in each axis direction. Further, the computer apparatus 104 may include a terminal or a server. The terminal may include, but is not limited to, various personal computers, laptops, smartphones, tablets, Internet of Things devices, and portable wearable devices. The server may be implemented using a standalone server or a server cluster composed of a plurality of servers.

For example, the computer device 104 is described as a terminal device, the internal configuration of which is shown in FIG. 2. The computer apparatus includes a processor, a memory, a communication interface, a display and an input device connected through a system bus. The processor of the computer apparatus is used to provide computing and control capabilities. The memory of the computer apparatus includes a non-volatile storage medium and an internal memory. The non-volatile storage medium stores an operating system and a computer program. The internal memory provides an environment for operation of the operating system and the computer program in the non-volatile storage medium. The communication interface of the computer apparatus is used to communicate with an external terminal in a wired or wireless mode. The wireless mode may be realized by Wi-Fi, mobile cellular network, near field communication (NFC) or other technologies. The computer program is executed by the processor to realize a method for determining a magnetic resonance gradient correction compensation factor and a magnetic resonance gradient correction method. The display of the computer apparatus may be a liquid crystal display or an e-ink display, and the input device of the computer apparatus may be a touch layer overlaying the display, a button, a trackball, or a touchpad provided on an housing of the computer apparatus, or an external keyboard, a touchpad, or a mouse.

It will be understood by persons skilled in the art that the configuration illustrated in FIG. 2 is only a block diagram of a portion of the configuration related to the embodiment of present disclosure, and does not constitute a limitation on the computer apparatus to which the embodiment of the present disclosure is applied, and that a specific computer apparatus may include more or fewer components than shown in the figure, or a combination of some of the components, or have a different arrangement of the components.

The following embodiments first illustrate a method for determining a magnetic resonance gradient correction compensation factor.

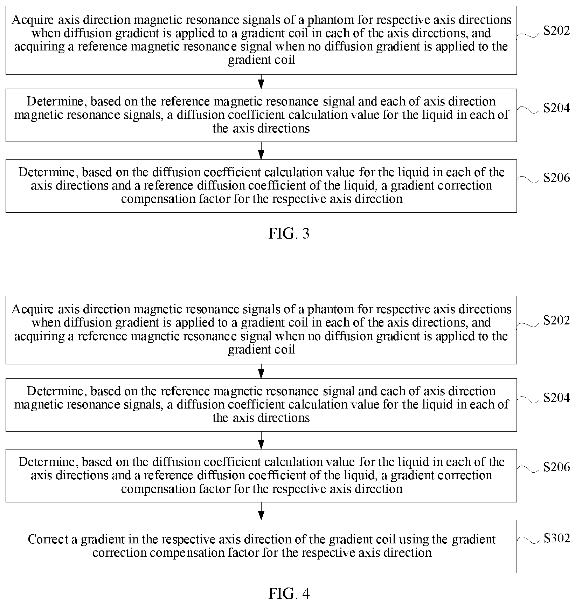

In an embodiment, as shown in FIG. 3, a method for determining a magnetic resonance gradient correction compensation factor is provided. This method is described as being applied to the computer apparatus in FIG. 2 as an example. The method may include the following steps S202 to S206.

In step S202, axis direction magnetic resonance signals for respective axis directions of the phantom when diffusion gradient is applied to a gradient coil in each of the axis directions are acquired, and a reference magnetic resonance signal when no diffusion gradient is applied to the gradient coil is acquired. The phantom is filled with liquid, and the liquid is isotropic.

In this step, the phantom may be partially or completely filled with liquid. The liquid is isotropic, which means that the liquid has the same properties in all directions. The geometry of the phantom may be completely spherical or not completely spherical, for example, ellipsoid or the like. The liquid may be water, oil or other liquids. Optionally, the phantom in this embodiment may be a spherical water phantom filled with liquid. In addition, optionally, the phantom may be placed in a magnet at any position in a gradient linearity volume where the gradient keeps linearity. The gradient linearity volume is generally in the region near the center of the magnet. For example, for the gradient field of 9.4T magnetic resonance system, the gradient has a linearity volume about 10 cm of magnet isocenter. Limited by the shape and geometry of the gradient coil, the rate of change of the strength of the gradient field within the spatial range of the linearity volume is the same within a unit distance. That is, in this embodiment, there is no limitation to the position of the phantom in the main magnet as long as the phantom is fixed in the main magnet. There is no requirement for the positioning of the phantom, so it is easier to place the phantom during the implementation of the gradient correction, which can improve the efficiency of the gradient correction.

Specifically, the phantom may be set in advance, and placed in the main magnet at any position where the gradient keeps linearity. And then, if no diffusion gradient is applied to the gradient coil, a magnetic resonance scan may be performed on the phantom to obtain a reference magnetic resonance signal. After obtaining the reference magnetic resonance signal, diffusion gradient may be applied to the gradient coil in each of the axis directions. The position of the phantom remains unchanged, and the magnetic resonance scan is performed on the phantom after the gradient is applied, to obtain the magnetic resonance signals in the respective axis directions.

The above diffusion gradient refers to the gradient applied to the gradient coil during the diffusion tensor imaging process. Optionally, applying the diffusion gradient to the gradient coil in each of the axis directions means that the diffusion gradient applied to the gradient coil acts in orthogonal x, y, and z axis directions, respectively. In some embodiments, the x, y, and z axis directions may be axis directions of three physical axis of a world coordinate system of the magnetic resonance system. In some embodiments, the z axis direction is parallel to a main magnetic field direction. The same diffusion gradient may be applied to the gradient coil in these three axis directions to facilitate subsequent rapid determination of the gradient correction compensation factors and rapid gradient correction. In some embodiments, different diffusion gradients may be applied in different axis directions.

In step S204, a diffusion coefficient calculation value for the liquid in each of the axis directions is determined based on the reference magnetic resonance signal and each of axis direction magnetic resonance signals.

In this step, a set magnetic resonance parameter $b_{\text{theory}}^i$ for each of the axis directions may be acquired first, and a preset mathematical function is used to perform a mathematical operation on the set magnetic resonance parameter, the axis direction magnetic resonance signals, and the reference magnetic resonance signal, to determine the diffusion coefficient calculation value of the liquid in each of the axis directions. In some embodiments, the magnetic resonance parameter $b_{\text{theory}}^i$ set for each of the axis directions may be the same. In some embodiments, the magnetic resonance parameter $b_{\text{theory}}^i$ set for each of the axis directions may be different.

The magnetic resonance parameter is a value related to the applied diffusion gradient amplitude, the diffusion gradient duration and the diffusion gradient separation time. The magnetic resonance parameter has a square relationship with the magnitude of the gradient, that is, proportional to the square of the gradient. Before performing a magnetic resonance scan, when setting the scan sequence in the magnetic resonance system, the set magnetic resonance parameter $b_{\text{theory}}^i$ for each of the axis directions may be determined based on the set scan sequence. During the magnetic resonance scan, the value of the actual magnetic resonance parameter $b_{\text{practice}}^i$ for each of the axis directions is determined based on the diffusion gradient applied to the gradient coil in each of the axis directions during the actual scanning process. For example, if the applied gradient is accurate, the actual magnetic resonance parameter $b_{\text{practice}}^i$ for each of the axis directions is equal to the set magnetic resonance parameter for each of the axis directions. If the applied gradient is incorrect, the value of the actual magnetic resonance parameter $b_{\text{practice}}^i$ in each of the axis directions may not be the magnetic resonance parameter $b_{\text{theory}}^i$ set for each of the axis directions when initially setting up the scan sequence.

Specifically, the following formula (1) may be used to calculate the diffusion coefficient calculation value of the liquid in each of the axis directions. The formula (1) is as follows:

$$D_i = (ln\, S_0 - ln\, S_i)/b_{\text{theory}}^i \quad (1),$$

The formula (1) or the modification of the formula (1) may be used as a mathematical function in this step. $i$ refers to the respective axis direction. $D_i$ refers to the diffusion coefficient calculation value in each of the axis directions. $S_0$ refers to reference magnetic resonance signal. $S_i$ refers to the axis direction magnetic resonance signal acquired when the diffusion gradient is applied in $i$ axis direction.

After acquiring the axis direction magnetic resonance signals, the reference magnetic resonance signal, and the magnetic resonance parameter $b_{\text{theory}}^i$ set when setting up the scan sequence, all the determined parameters may be substituted into the above formula (1) or the modification of the formula (1) respectively to calculate the diffusion coefficient calculation value $D_i$ in each of the axis directions.

In step S206, the actual magnetic resonance parameter $b_{\text{practice}}^i$ in each of the axis directions may be determined based on the diffusion coefficient calculation value for the liquid in each of the axis directions and the reference diffusion coefficient. The gradient correction compensation factor for the respective axis direction may be determined based on the square relationship between the magnetic resonance parameter and the magnitude of the gradient.

In this step, after determining the diffusion gradient calculation value of the liquid in each of the axis directions, the preset reference diffusion coefficient may also be determined, and then the diffusion coefficient calculation value in each of the axis directions and the reference diffusion coefficient may be subjected to mathematical operations respectively to obtain the gradient correction compensation factor for the respective axis direction.

Before the step S206, the reference diffusion coefficient may also be determined in advance.

In some embodiments, the reference diffusion coefficient may be an intrinsic diffusion coefficient of the liquid. For example, the liquid may be water, and the intrinsic diffusion coefficient (i.e., the reference diffusion coefficient) of the water may be $3 \times 10^{-3}$ mm$^2$/s. Accordingly, calculation may be performed in the step S206 as following: calculation with the diffusion coefficient calculation value in each of the axis directions and the reference diffusion coefficient is performed respectively, to obtain the gradient correction compensation factor for the respective axis direction.

In the above method for determining magnetic resonance gradient correction compensation factor, diffusion coefficient calculation value for liquid in each of the axis directions is determined based on axis direction magnetic resonance signals of the phantom filled with isotropic liquid acquired when diffusion gradients are applied to the gradient coil, and a reference magnetic resonance signal acquired when no diffusion gradient is applied to the gradient coil. A gradient correction compensation factor for the respective axis direction is determined based on the diffusion coefficient calculation value for the liquid in each of the axis directions and a reference diffusion coefficient of the liquid. And then the gradient in the respective axis direction of the gradient coil is corrected using the gradient correction compensation factor for the respective axis direction. In this method, the diffusion coefficient calculation value for the liquid in each of the axis directions can be calculated using the intrinsic diffusion coefficient of the isotropic liquid, and the gradient correction compensation factor for the respective axis directions can be calculated based on the diffusion coefficient calculation value in the respective axis direction. The calculation of the gradient correction compensation factor has no limit for the position and size of the phantom, that is, it is independent of the position and size of the phantom. As a result, the determined gradient correction compensation factor for each of the axis directions is more accurate. And when each gradient correction compensation factor is used for gradient correction, the accuracy of the obtained correction result can be also improved, that is, the accuracy of the gradient correction for each of the axis directions can be improved. In addition, since there is no need to specify the position and size of the phantom, it can save time for designing or positioning the phantom, simplify the gradient correction process, and thus improve the efficiency of the gradient correction process.

In the above embodiment, it is described that the gradient correction compensation factor for the respective axis direction may be determined. Before determining the gradient correction compensation factor, it may also be determined in advance whether the gradient in each of the axis directions is correct, and then the gradient correction of the axis direction with an incorrect gradient may be performed. This process is explained in detail below. In another embodiment, another method for determining the magnetic resonance gradient correction compensation factor is provided. Based on the above embodiment, the determining, based on the diffusion coefficient calculation value for the liquid in each of the axis directions and the reference diffusion coefficient, the gradient correction compensation factor for the respective axis direction in the step S206 specifically includes the following steps A1 to A3.

In step A1, the diffusion coefficient calculation values in the respective axis directions are compared with the reference diffusion coefficient to obtain a comparison result.

In step A2, it is determined, based on the comparison result, whether the gradient in each of the axis directions of the gradient coil is correct.

In step A3, if the gradient in one of the axis directions of the gradient coil is incorrect, the gradient correction compensation factor for the one axis direction is determined based on the diffusion coefficient calculation value of the liquid in the one axis direction and the reference diffusion coefficient.

In some embodiments, the determining, based on the diffusion coefficient calculation value for the liquid in each of the axis directions and the reference diffusion coefficient, the gradient correction compensation factor for the respective axis direction in the step S206 further includes a step A4 as following: if the gradient in one of the axis directions of the gradient coil is correct, the gradient correction compensation factor for the one axis direction is determined to be 1, or the gradient in the one axis direction is determined to be not corrected..

After the reference diffusion coefficient has been determined, the diffusion coefficient calculation value in each of the axis directions may be compared with the reference diffusion coefficient to determine whether the diffusion coefficient calculation value in each of the axis directions is equal to the reference diffusion coefficient. The comparison process may include, for example, calculating the difference between the diffusion coefficient calculation value in each of the axis directions and the reference diffusion coefficient, and comparing each calculated difference with 0; determining, if the difference corresponding to the diffusion coefficient calculation value in one of the axis directions is not equal to 0, the gradient in the one axis direction is incorrect; and determining, if the difference corresponding to the diffusion coefficient calculation value in one of the axis directions is equal to 0, the gradient in the one axis direction is correct. Alternatively, the ratio between the diffusion coefficient calculation value in each of the axis directions and the reference diffusion coefficient may be calculated, and each calculated ratio may be compared with 1. If the ratio corresponding to the diffusion coefficient calculation value in one of the axis directions is not equal to 1, it is determined that the gradient in the one axis direction is incorrect. If the ratio corresponding to the diffusion coefficient calculation value in one of the axis directions is equal to 1, it is determined that the gradient in the one axis direction is correct. Of course, other comparison methods may also be used here.

It should be noted that for isotropic liquids, the diffusion coefficient calculation values obtained in all the axis directions should be the same. If they are different, it means that the gradient in one or more axis directions is inaccurate, and it is necessary to correct the gradient in the one or more axis directions.

In this embodiment, by comparing the diffusion coefficient calculation value in each of the axis directions with the reference diffusion coefficient, and determining whether the gradient in each of the axis directions of the gradient coil is correct based on the obtained comparison result, the axis direction with an incorrect gradient can be determined accurately and quickly, and the gradient in that axis direction of the magnetic resonance system can be corrected accurately and quickly. For an axis direction of the gradient coil with an accurate gradient, the gradient correction compensation factor for the axis direction is determined to be 1, or the gradient in the axis direction is determined to be not corrected, to reduce the amount of calculation and avoid blind gradient correction, thereby improving the accuracy of the gradient correction and the efficiency of the gradient correction.

In the above embodiment, it is described that the gradient correction compensation factor for each of the axis directions can be obtained by performing mathematical operation on the diffusion coefficient calculation value in each of the axis directions and the reference diffusion coefficient. The following is a detailed description of how to determine the gradient correction compensation factor for the respective axis direction. The above step S206 may include the following step B.

In the step B, the gradient correction compensation factor for the respective axis direction is calculated according to a formula of $k_i = \sqrt{D_i/D_0}$, where $i$ refers to the respective axis direction. $k_i$ refers to the gradient correction compensation factor for the respective axis direction, $D_i$ refers to the diffusion coefficient calculation value in the respective axis direction, and $D_0$ refers to the reference diffusion coefficient.

In this step, after the diffusion coefficient calculation value for each of the axis directions is obtained, and the axis direction where the gradient is incorrect is known, the gradient correction compensation factor for the axis direction with the incorrect gradient may be calculated.

The formula for calculating the gradient correction compensation factor is first deduced below, that is, the above formula (2) is deduced. The process is as follows.

Assuming that the axis direction with the incorrect gradient is the y axis direction, the following formula may be used:

$$b_{\text{practice}}^y = b_{\text{theory}}^y \times \frac{D_y}{D_0} \quad (3)$$

The actual magnetic resonance parameter value $b_{\text{practice}}^y$ is calculated. $b_{\text{thoery}}^y$ is a magnetic resonance parameter for the y axis direction determined when setting up the scan sequence, which is a known quantity. $D_y$ is the diffusion coefficient calculation value calculated based on the magnetic resonance signal applying the diffusion gradient to the y axis direction, and the reference magnetic resonance signal. $D_0$ refers to the reference diffusion coefficient.

Meanwhile, it can be seen from the description about the above step S204 that the magnetic resonance parameter has a square relationship with the magnitude of the gradient, that is, the magnetic resonance parameter is proportional to the square of the diffusion gradient. The relationship between the magnetic resonance parameter and the magnitude of the gradient may be expressed by the following formula (4):

$$b \propto G^2 \quad (4),$$

where & refers to the magnetic resonance parameter, and G refers to the magnitude of the gradient.

By converting the formulas (3) and (4), the following formula (5) can be obtained:

$$\frac{b_{\text{theory}}^y}{b_{\text{practice}}^y} = \frac{D_0}{D_y} = \frac{(G_{\text{theory}}^y)^2}{(G_{\text{practice}}^y)^2} \quad (5),$$

where $G_{\text{theory}}^y$ refers to the gradient set for the *y axis* direction, and $G_{\text{practice}}^y$ refers to the actual magnitude of the gradient in the y axis direction. By taking a root of the formula (5), the following formula (6) may be obtained:

$$\sqrt{\frac{D_y}{D_0}} = \frac{G_{\text{practice}}^y}{G_{\text{theory}}^y} = k_y \quad (6).$$

By converting the y axis direction in the formula (6) to any axis direction, that is, replacing $D_y$ with $D_i$, and $k_y$ with $k_i$, the above formula (2) may be obtained.

After obtaining the above formula (2), the diffusion coefficient calculation value in the axis direction with the incorrect gradient and the reference diffusion coefficient may be substituted into the formula (2) for calculation, and the gradient correction compensation factor in the axis direction can be obtained.

In this embodiment, the compensation factor in the axis direction with the incorrect gradient is calculated using the gradient correction compensation factor calculation formula including the diffusion coefficient calculation value and the reference diffusion coefficient. The gradient correction compensation factor in the axis direction can be obtained quickly and accurately, to improve the accuracy and efficiency of obtaining the gradient correction compensation factor. Furthermore, the gradient in the axis direction can also be corrected quickly and accurately based on the gradient correction compensation factor, thereby improving the accuracy and efficiency of the gradient correction.

In the above embodiment, the diffusion gradient is applied to the gradient coil in each axis direction, and the correction compensation factor of the magnetic resonance gradient for the respective axis direction is determined based on the diffusion coefficient calculation value for the liquid in each of the axis directions and the reference diffusion coefficient. After the magnetic resonance gradient correction compensation factor is determined, the magnetic resonance gradient correction may be performed. The following embodiment will continue to explain the magnetic resonance gradient correction method based on the above embodiment.

In an embodiment, as shown in FIG. 4, a magnetic resonance gradient correction method is provided. This method is described by taking the method applied to the computer apparatus shown in FIG. 2 as an example. Based on the above embodiment, the method may also include the following step S302.

In step S302, the gradient in the respective axis direction of the gradient coil is corrected using the gradient correction compensation factor for the respective axis direction.

In this embodiment, by obtaining the gradient correction compensation factor for each of the axis directions, the gradient in the respective axis direction may be corrected respectively to ensure the accuracy of the magnetic resonance gradient and improve the accuracy and efficiency of the gradient correction.

In order to better describe the technical solution of the embodiment of the present disclosure, the technical solution of the present disclosure is described below with reference to a specific embodiment. Based on the above embodiment, the method may include the following steps S1 to S6.

In step S1, axis direction magnetic resonance signals $S_i$ of the phantom filled with isotropic liquid are acquired when diffusion gradients are applied to the gradient coil, and a reference magnetic resonance signal $S_0$ is acquired when no diffusion gradient is applied to the gradient coil.

In step S2, the set magnetic resonance param-

eter $b_{\text{theory}}^i$ for each of the axis directions is acquired, and a preset mathematical function of

$$D_i = (ln\,S_0 - ln\,S_i)/b_{\text{theory}}^i$$

is used to perform a mathematical operation on the magnetic resonance parameter, the axis direction magnetic resonance signals, and reference magnetic resonance signal, to determine the diffusion coefficient calculation value of the liquid in each of the axis directions.

In step S3, the diffusion coefficient calculation value in each of the axis directions is compared with the reference diffusion coefficient, to obtain the comparison result. The reference diffusion coefficient may be the intrinsic diffusion coefficient of the liquid.

In step S4, it is determined whether the gradient in each of the axis directions of the gradient coil is correct based on the comparison result.

In step S5, if the gradient in a certain axis direction is incorrect, the formula $k_i = \sqrt{D_i/D_0}$ is used to calculate the gradient correction compensation factor in the axis direction based on the diffusion coefficient calculation value in the axis direction and the reference diffusion coefficient.

In step S6, if the gradient in a certain axis direction is correct, the gradient correction compensation factor in the axis direction is set to 1, or the gradient in the axis direction is not corrected.

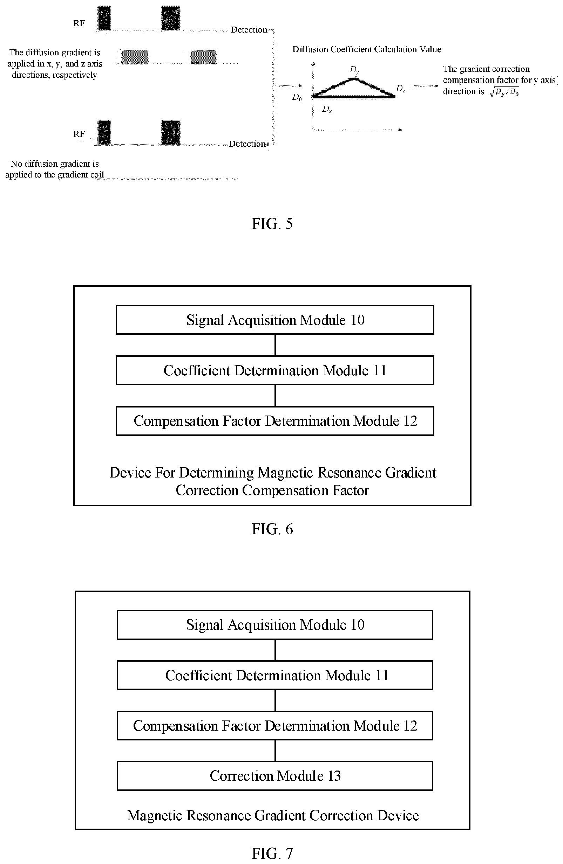

For details, as shown in FIG. 5, magnetic resonance signals are acquired when the diffusion gradient is not applied to the gradient coil, and when the diffusion gradient is applied to the x, y, and z axis directions, respectively. The magnitude of the diffusion gradient applied in each of the axis directions may be changed. According to the above calculation method, the diffusion coefficient calculation value of the liquid (such as water) in each of the axis directions and the gradient correction compensation factor of $\sqrt{D_y/D_0}$ for the axis direction where the gradient is incorrectly applied (such as the y axis direction in the FIG. 5) may be calculated, and then the gradient correction may be performed.

It should be noted that, in the embodiments of the present disclosure, the mode of applying the diffusion gradient is not limited, and the mode of applying the diffusion gradient is not necessarily a double-gradient mode, and other modes may also be used to apply the diffusion gradient. Only an example is shown in FIG. 5.

It should be understood that although the steps in the flowcharts involved in the above embodiments are shown in sequence as indicated by the arrows, these steps are not necessarily executed in the order indicated by the arrows. Unless explicitly stated in this article, there is no strict order restriction on the execution of these steps, and these steps may be executed in other orders. Moreover, at least some of the steps in the flowcharts involved in the above embodiments may include multiple steps or multiple stages. These steps or stages are not necessarily executed at the same time, but may be executed at different times. The execution order of these steps or stages is not necessarily sequential, but may be performed in turn or alternately with other steps or at least part of the steps or stages in other steps.

Based on the same inventive concept, embodiments of the present disclosure also provide a device for determining a magnetic resonance gradient correction compensation factor used to implement the method for determining the magnetic resonance gradient correction compensation factor. The solution for solving the problem provided by the device is similar to the solution described in the above method. Therefore, the specific limitations in the following one or more embodiments of the device for determining the magnetic resonance gradient correction compensation factor may refer to the definition of the method for determining the magnetic resonance gradient correction compensation factor described above, and details will not be described herein again.

In an embodiment, as shown in FIG. 6, a device for determining a magnetic resonance gradient correction compensation factor is provided. The device includes: a signal acquisition module 10, a coefficient determination module 11 and a compensation factor determination module 12.

The signal acquisition module 10 is configured to acquire axis direction magnetic resonance signals of a phantom for respective axis directions when diffusion gradient is applied to a gradient coil in each of the axis directions, and acquire a reference magnetic resonance signal when no diffusion gradient is applied to the gradient coil. The phantom is filled with liquid, and the liquid is isotropic.

The coefficient determination module 11 is configured to determine, based on the reference magnetic resonance signal and each of axis direction magnetic resonance signals, a diffusion coefficient calculation value for the liquid in each of the axis directions.

The compensation factor determination module 12 is configured to determine, based on the diffusion coefficient calculation value for the liquid in each of the axis directions and a reference diffusion coefficient of the liquid, a gradient correction compensation factor for the respective axis direction.

Optionally, the phantom is placed in the magnet at any position where the gradient keeps linearity.

Optionally, the reference diffusion coefficient may be the intrinsic diffusion coefficient of the liquid.

In some embodiments, a diffusion coefficient calculation value closest to the intrinsic diffusion coefficient of the liquid among the diffusion coefficient calculation values for the liquid in all the axis directions is used as the reference diffusion coefficient. Specifically, the difference between the diffusion coefficient calculation value in each of the axis directions and the intrinsic diffusion coefficient of the liquid is calculated, and the diffusion coefficient in the respective axis direction with the smallest absolute value of the difference is used as the reference diffusion coefficient.

In another embodiment, applying the diffusion gradient to the gradient coil in each of the axis directions specifically means that the diffusion gradient applied on the gradient coil acts in orthogonal x, y, and z axis directions, respectively. In some embodiments, the x, y, and z axis directions may be axis directions of three physical axis of a world coordinate system of the magnetic resonance system. In some embodiments, the z axis direction is parallel to a main magnetic field direction.

In another embodiment, another device for determining a magnetic resonance gradient correction compensation factor is provided. Based on the above embodiment, the above compensation factor determination module 12 may include a compensation factor calculation unit configured to calculate the gradient correction compensation factor for the respective axis direction according to a formula of $k_i = \sqrt{D_i/D_0}$, where $i$ refers to the respective axis direction, $k_i$ refers to the gradient correction compensation factor for the respective axis direction, $D_i$ refers to the diffusion coefficient calculation value in the respective axis direction, and $D_0$ refers to the reference diffusion coefficient.

In another embodiment, a magnetic resonance gradient correction device is provided, as shown in FIG. 7. Based on the above embodiment, the magnetic resonance gradient correction device may include: a signal acquisition module 10, a coefficient determination module 11, a compensation factor determination module 12 and a correction module 13.

The signal acquisition module 10 is configured to acquire axis direction magnetic resonance signals of a phantom for respective axis directions when diffusion gradient is applied to the gradient coil in each of the axis directions, and acquire a reference magnetic resonance signal when no diffusion gradient is applied to the gradient coil. The phantom is filled with liquid, and the liquid is isotropic.

The coefficient determination module 11 is configured to determine, based on the reference magnetic resonance signal and each of axis direction magnetic resonance signals, a diffusion coefficient calculation value for the liquid in each of the axis directions.

The compensation factor determination module 12 is configured to determine, based on the diffusion coefficient calculation value for the liquid in each of the axis directions and a reference diffusion coefficient of the liquid, a gradient correction compensation factor for the respective axis direction.

The correction module 13 is configured to correct a gradient of the gradient coil in the respective axis direction using the gradient correction compensation factor for the respective axis direction.

Each module in both the device for determining the magnetic resonance gradient correction compensation factor and the magnetic resonance gradient correction device may be realized in whole or in part by software, hardware and combinations thereof. Each of the above modules may be embedded in or independent of the processor of the computer apparatus in the form of hardware, or may be stored in the memory of the computer apparatus in the form of software, so that the processor can call and execute the operations corresponding to the above modules.

In an embodiment, a magnetic resonance system including a magnetic resonance scan apparatus and a computer apparatus connected to each other is provided. The magnetic resonance scan apparatus includes a main magnet and a gradient coil. The computer apparatus includes a memory and a processor, and the memory stores a computer program. The processor, when executing the computer program, implements the following steps.

Axis direction magnetic resonance signals of a phantom for respective axis directions are acquired when diffusion gradient is applied to the gradient coil in each of the axis directions, and a reference magnetic resonance signal is acquired when no diffusion gradient is applied to the gradient coil. The phantom is filled with liquid, and the liquid is isotropic. A diffusion coefficient calculation value for the liquid in each of the axis directions is determined based on the reference magnetic resonance signal and each of axis direction magnetic resonance signals. A gradient correction compensation factor for the respective axis direction is determined based on the diffusion coefficient calculation value for the liquid in each of the axis directions and a reference diffusion coefficient of the liquid.

In an embodiment, the processor, when executing the computer program, implements the following step.

A mathematical operation on the diffusion coefficient calculation value in each of the axis directions and the reference diffusion coefficient is performed to obtain the gradient correction compensation factor for the respective axis direction. The above reference diffusion coefficient may be the diffusion coefficient calculation value closest to the intrinsic diffusion coefficient of the liquid among the diffusion coefficient calculation values in all the axis directions.

In an embodiment, the reference diffusion coefficient may be the intrinsic diffusion coefficient of the liquid.

In an embodiment, the diffusion gradient applied on the gradient coil acts in orthogonal x, y, and z axis directions, respectively.

In an embodiment, the above phantom is placed in the magnet at any position where the gradient keeps linearity.

In an embodiment, the processor, when executing the computer program, implements the following step.

The gradient correction compensation factor for the respective axis direction is calculated according to a formula of $k_i = \sqrt{D_i/D_0}$, where $i$ refers to the respective axis direction, $k_i$ refers to the gradient correction compensation factor for the respective axis direction, $D_i$ refers to the diffusion coefficient calculation value in the respective axis direction, and $D_0$ refers to the reference diffusion coefficient.

In an embodiment, a computer apparatus including a memory and a processor is provided. A computer program is stored in the memory. The processor, when executing the computer program, implements the following steps.

Axis direction magnetic resonance signals of a phantom for respective axis directions are acquired when diffusion gradient is applied to a gradient coil in each of the axis directions, and a reference magnetic resonance signal is acquired when no diffusion gradient is applied to the gradient coil. The phantom is filled with liquid, and the liquid is isotropic. A diffusion coefficient calculation value for the liquid in each of the axis directions is determined based on the reference magnetic resonance signal and each of axis direction magnetic resonance signals. A gradient correction compensation factor for the respective axis direction is determined based on the diffusion coefficient calculation value for the liquid in each of the axis directions and a reference diffusion coefficient of the liquid. A gradient of the gradient coil in the respective axis direction is corrected using the gradient correction compensation factor for the respective axis direction.

In an embodiment, a computer-readable storage medium having a computer program stored thereon is provided. When the computer program is executed by a processor, the following step is implemented.

Axis direction magnetic resonance signals of a phantom for respective axis directions are acquired when diffusion gradient is applied to the gradient coil in each of the axis directions, and a reference magnetic resonance signal is acquired when no diffusion gradient is applied to the gradient coil. The phantom is filled with liquid, and the liquid is isotropic. A diffusion coefficient calculation value for the liquid in each of the axis directions is determined based on the reference magnetic resonance signal and each of axis direction magnetic resonance signals. A gradient correction compensation factor for the respective axis direction is determined based on the diffusion coefficient calculation value for the liquid in each of the axis directions and a reference diffusion coefficient of the liquid.

In an embodiment, the computer program, when executed by the processor, also implements the following step.

A mathematical operation on the diffusion coefficient calculation value in each of the axis directions and the reference diffusion coefficient is performed to obtain the gradient correction compensation factor for the respective axis direction. The above reference diffusion coefficient may be the diffusion coefficient calculation value closest to the intrinsic diffusion coefficient of the liquid among the diffusion coefficient calculation values in all the axis directions.

In an embodiment, the reference diffusion coefficient may be the intrinsic diffusion coefficient of the liquid.

In an embodiment, the diffusion gradient applied on the gradient coil acts in orthogonal x, y, and z axis directions, respectively.

In an embodiment, the above phantom is placed in the magnet at any position where the gradient keeps linearity.

In an embodiment, the computer program, when executed by the processor, also implements the following step.

The gradient correction compensation factor for the respective axis direction is calculated according to a formula of $k_i = \sqrt{D_i/D_0}$, where $i$ refers to the respective axis direction, $k_i$ refers to the gradient correction compensation factor for the respective axis direction, $D_i$ refers to the diffusion coefficient calculation value in the respective axis direction, and $D_0$ refers to the reference diffusion coefficient.

In an embodiment, a computer-readable storage medium having a computer program stored thereon is provided. When the computer program is executed by a processor, the following step is implemented.

Axis direction magnetic resonance signals of a phantom for respective axis directions are acquired when diffusion gradient is applied to a gradient coil in each of the axis directions, and a reference magnetic resonance signal is acquired when no diffusion gradient is applied to the gradient coil. The phantom is filled with liquid, and the liquid is isotropic. A diffusion coefficient calculation value for the liquid in each of the axis directions is determined based on the reference magnetic resonance signal and each of axis direction magnetic resonance signals. A gradient correction compensation factor for the respective axis direction is determined based on the diffusion coefficient calculation value for the liquid in each of the axis directions and a reference diffusion coefficient of the liquid. A gradient of the gradient coil in the respective axis direction is corrected using the gradient correction compensation factor for the respective axis direction.

In an embodiment, a computer program product including a computer program is provided. When the computer program is executed by a processor, the following step is implemented.

Axis direction magnetic resonance signals of a phantom for respective axis directions are acquired when diffusion gradient is applied to a gradient coil in each of the axis directions, and a reference magnetic resonance signal is acquired when no diffusion gradient is applied to the gradient coil. The phantom is filled with liquid, and the liquid is isotropic. A diffusion coefficient calculation value for the liquid in each of the axis directions is determined based on the reference magnetic resonance signal and each of axis direction magnetic resonance signals. A gradient correction compensation factor for the respective axis direction is determined based on the diffusion coefficient calculation value for the liquid in each of the axis directions and a reference diffusion coefficient of the liquid.

In an embodiment, the computer program, when executed by the processor, also implements the following step.

A mathematical operation on the diffusion coefficient calculation value in each of the axis directions and the reference diffusion coefficient is performed to obtain the gradient correction compensation factor for the respective axis direction. The above reference diffusion coefficient may be the diffusion coefficient calculation value closest to the intrinsic diffusion coefficient of the liquid among the diffusion coefficient calculation values in all the axis directions.

In an embodiment, the reference diffusion coefficient may be the intrinsic diffusion coefficient of the liquid.

In an embodiment, the diffusion gradient applied on the gradient coil acts in orthogonal x, y, and z axis directions, respectively.

In an embodiment, the above phantom is placed in the magnet at any position where the gradient keeps linearity.

In an embodiment, the computer program, when executed by the processor, also implements the following step.

The gradient correction compensation factor for the respective axis direction is calculated according to a formula of $k_i = \sqrt{D_i/D_0}$, where $i$ refers to the respective axis direction, $k_i$ refers to the gradient correction compensation factor for the respective axis direction, $D_i$ refers to the diffusion coefficient calculation value in the respective axis direction, and $D_0$ refers to the reference diffusion coefficient.

In an embodiment, a computer program product including a computer program is provided. When the computer program is executed by a processor, the following step is implemented.

Axis direction magnetic resonance signals of a phantom for respective axis directions are acquired when diffusion gradient is applied to a gradient coil in each of the axis directions, and a reference magnetic resonance signal is acquired when no diffusion gradient is applied to the gradient coil. The phantom is filled with liquid, and the liquid is isotropic. A diffusion coefficient calculation value for the liquid in each of the axis directions is determined based on the reference magnetic resonance signal and each of axis direction magnetic resonance signals. A gradient correction compensation factor for the respective axis direction is determined based on the diffusion coefficient calculation value for the liquid in each of the axis directions and a reference diffusion coefficient of the liquid. A gradient of the gradient coil in the respective axis direction is corrected using the gradient correction compensation factor for the respective axis direction.

It should be noted that the data (including but not limited to data used for analysis, stored data, displayed data, etc.) involved in the present disclosure is information and data authorized by the user or fully authorized by all parties.

A person of ordinary skill in the art may understand that implementation of all or part of the processes in the methods of the above embodiments may be completed by instructing the relevant hardware through a computer program. The computer program may be stored in a non-transitory computer-readable storage medium. When the computer program is executed, it may include the processes of the embodiments of the above methods. Any reference to memory, database or other medium used of the embodiments provided in the present disclosure may include at least one of a non-transitory and a transitory memory. The non-volatile memory may include a read-only memory (ROM), a magnetic tape, a floppy disk, a flash memory, an optical memory, a high-density embedded non-volatile memory, a resistive memory (ReRAM), a magnetoresistive random access memory (MRAM), a ferroelectric random access memory (FRAM), a phase change memory (PCM), a graphene memory, etc. The volatile memory may include a random access memory (RAM), an external cache memory, etc. As an illustration and not a limitation, RAM may be in various forms, such as a static random access memory (SRAM) or a dynamic random access memory (DRAM). The databases involved in the various embodiments provided in the present disclosure may include at least one of a relational database and a non-relational database. The non-relational database may include a blockchain-based distributed database or the like, but is not limited thereto. The processor involved in the various embodiments provided in the present disclosure may be a general-purpose processor, a central processing unit, a graphics processor, a digital signal processor, a programmable logic device, a quantum computing-based data processing logic device, or the like, but is not limited thereto.

The technical features in the above embodiments may be combined arbitrarily. For concise description, not all possible combinations of the technical features in the above embodiments are described. However, provided that they do not conflict with each other, all combinations of the technical features are to be considered to be within the scope described in this specification.

The above-mentioned embodiments only describe several implementations of the present disclosure, and their description is specific and detailed, but should not be understood as a limitation on the patent scope of the present disclosure. It should be noted that, for a person of ordinary skill in the art may further make variations and improvements without departing from the conception of the present disclosure, and these all fall within the protection scope of the present disclosure. Therefore, the protection scope of the present disclosure should be subject to the appended claims.

**Claims**

1. A method for determining a magnetic resonance gradient correction compensation factor, **characterized by** comprising:

   acquiring axis direction magnetic resonance signals of a phantom for respective axis directions when diffusion gradient is applied to a gradient coil in each of the axis directions, and acquiring a reference magnetic resonance signal when no diffusion gradient is applied to the gradient coil, wherein the phantom is filled with liquid, and the liquid is isotropic;
   determining, based on the reference magnetic resonance signal and each of axis direction magnetic resonance signals, a diffusion coefficient calculation value for the liquid in each of the axis directions; and
   determining, based on the diffusion coefficient calculation value for the liquid in each of the axis directions and a reference diffusion coefficient of the liquid, a gradient correction compensation factor for the respective axis direction.

2. The method according to claim 1, **characterized in that** the reference diffusion coefficient is an intrinsic diffusion coefficient of the liquid.

3. The method according to claim 1, **characterized in that** a diffusion coefficient calculation value closest to the intrinsic diffusion coefficient of the liquid among the diffusion coefficient calculation values for the liquid in all the axis directions is used as the reference diffusion coefficient.

4. The method according to claim 1, **characterized in that** the diffusion gradient applied to the gradient coil acts in orthogonal x, y, and z axis directions, respectively.

5. The method according to claim 4, **characterized in that** the orthogonal x, y, and z axis directions are three axis directions of a world coordinate system of a magnetic resonance system.

6. The method according to claim 1, **characterized in that** the phantom is placed in a magnet at any position where the gradient keeps linearity.

7. The method according to claim 1, **characterized in that** the determining, based on the diffusion coefficient calculation value for the liquid in each of the axis directions and the reference diffusion coefficient, the gradient correction compensation factor for the respective axis direction comprises:
calculating the gradient correction compensation factor for the respective axis direction according to a formula of $k_i = \sqrt{D_i/D_0}$ , where $i$ refers to the respective axis direction, $k_i$ refers to the gradient correction compensation factor for the respective axis direction, $D_i$ refers to the diffusion coefficient calculation value in the respective axis direction, and $D_0$ refers to the reference diffusion coefficient.

8. The method according to claim 1, **characterized in that** the determining, based on the diffusion coefficient calculation value for the liquid in each of the axis directions and the reference diffusion coefficient, the gradient correction compensation factor for the respective axis direction comprises:

   comparing the diffusion coefficient calculation values in the respective axis directions with the reference diffusion coefficient to obtain a comparison result;
   determining, based on the comparison result, whether a gradient of the gradient coil in each of the axis directions of the gradient coil is correct; and
   determining, based on the diffusion coefficient calculation value of the liquid in one of the axis directions and the reference diffusion coefficient, the gradient correction compensation factor for the one axis direction, if the gradient of the gradient coil in the one axis direction is incorrect.

9. The method according to claim 8, **characterized in that** the determining, based on the comparison result, whether the gradient in each of the axis directions of the gradient coil is correct comprises:

   determining, if the diffusion coefficient calculation values in each of the axis directions is equal to the reference diffusion coefficient, the gradient in each of the axis directions of the gradient coil is correct; and
   determining, if the diffusion coefficient calculation value in one of the axis directions is not equal to the reference diffusion coefficient, the gradient in the one axis direction of the gradient coil is incorrect.

10. The method according to claim 8, **characterized in that** if the gradient in one of the axis directions of the gradient coil is correct, the gradient correction compensation factor for the one axis direction is determined to be 1, or the gradient in the one axis direction is determined to be not corrected.

11. The method according to claim 1, **characterized in that** before the determining, based on the reference magnetic resonance signal and each of axis direction magnetic resonance signals, the diffusion coefficient calculation value for the liquid in each of the axis directions, the method further comprises:
acquiring a set magnetic resonance parameter in each of the axis directions.

12. The method according to claim 11, **characterized in that** the determining, based on the reference magnetic resonance signal and each of axis direction magnetic resonance signals, the diffusion coefficient calculation value for the liquid in each of the axis directions comprises: determining the diffusion coefficient calculation value of the liquid in each of the axis directions by performing mathematical operation processing on the set magnetic resonance parameter in each of the axis directions, each of the axis direction magnetic resonance signals, and the reference magnetic resonance signal using a predetermined mathematical function.

13. The method according to claim 12, **characterized in that** the diffusion coefficient calculation value of the liquid in each of the axis directions is:

$$D_i = (ln\, S_0 - ln\, S_i)/b_{\text{theory}}^i \;,$$

where $i$ refers to the respective axis direction, $D_i$ refers to the diffusion coefficient calculation value in the respective axis direction, $S_0$ refers to the reference magnetic resonance signal, $S_i$ refers to the axis direction magnetic resonance signal acquired when the diffusion gradient is applied to i axis direction, and $b_{\text{theory}}^i$ is the set magnetic resonance parameter in the respective axis direction.

14. A magnetic resonance gradient correction method, **characterized by** comprising:
correcting a gradient in the respective axis direction of the gradient coil using the gradient correction compensation factor for the respective axis direction according to any one of claims 1 to 13.

15. A device for determining a magnetic resonance gradient correction compensation factor, **characterized by** comprising:

   a signal acquisition module configured to acquire axis direction magnetic resonance signals of a phantom for respective axis directions when diffusion gradient is applied to a gradient coil in each of the axis directions, and acquire a reference magnetic resonance signal when no diffusion gradient is applied to the gradient coil, wherein the phantom is filled with liquid, and the liquid is isotropic;

a coefficient determination module configured to determine, based on the reference magnetic resonance signal and each of axis direction magnetic resonance signals, a diffusion coefficient calculation value for the liquid in each of the axis directions; and

a compensation factor determination module configured to determine, based on the diffusion coefficient calculation value for the liquid in each of the axis directions and a reference diffusion coefficient of the liquid, a gradient correction compensation factor for the respective axis direction.

16. The device according to claim 15, **characterized in that** a diffusion coefficient calculation value closest to the intrinsic diffusion coefficient of the liquid among the diffusion coefficient calculation values for the liquid in all the axis directions is used as the reference diffusion coefficient.

17. A magnetic resonance gradient correction device, **characterized by** comprising:

the device for determining the magnetic resonance gradient correction compensation factor according to claim 15; and
a correction module configured to correct a gradient in the respective axis direction of the gradient coil using the gradient correction compensation factor for the respective axis direction.

18. A magnetic resonance system comprising a magnetic resonance scan apparatus and a computer apparatus connected to each other, the magnetic resonance scan apparatus comprising a main magnet and gradient coils, the computer apparatus comprising a processor and a memory storing a computer program, **characterized in that** the processor, when executing the computer program, implements steps of the method according to any one of claims 1 to 14.

19. A computer-readable storage medium having a computer program stored thereon, **characterized in that** when the computer program is executed by a processor, steps of the method according to any one of claims 1 to 14 are implemented.

20. A computer program product comprising a computer program, **characterized in that** when the computer program is executed by a processor, steps of the method according to any one of claims 1 to 14 are implemented.

FIG. 1

FIG. 2

Acquire axis direction magnetic resonance signals of a phantom for respective axis directions when diffusion gradient is applied to a gradient coil in each of the axis directions, and acquiring a reference magnetic resonance signal when no diffusion gradient is applied to the gradient coil — S202

Determine, based on the reference magnetic resonance signal and each of axis direction magnetic resonance signals, a diffusion coefficient calculation value for the liquid in each of the axis directions — S204

Determine, based on the diffusion coefficient calculation value for the liquid in each of the axis directions and a reference diffusion coefficient of the liquid, a gradient correction compensation factor for the respective axis direction — S206

FIG. 3

Acquire axis direction magnetic resonance signals of a phantom for respective axis directions when diffusion gradient is applied to a gradient coil in each of the axis directions, and acquiring a reference magnetic resonance signal when no diffusion gradient is applied to the gradient coil — S202

Determine, based on the reference magnetic resonance signal and each of axis direction magnetic resonance signals, a diffusion coefficient calculation value for the liquid in each of the axis directions — S204

Determine, based on the diffusion coefficient calculation value for the liquid in each of the axis directions and a reference diffusion coefficient of the liquid, a gradient correction compensation factor for the respective axis direction — S206

Correct a gradient in the respective axis direction of the gradient coil using the gradient correction compensation factor for the respective axis direction — S302

FIG. 4

RF

Detection

The diffusion gradient is applied in x, y, and z axis directions, respectively

Diffusion Coefficient Calculation Value

The gradient correction compensation factor for y axis direction is $\sqrt{D_y/D_0}$

$D_y$

$D_z$

$D_0$

$D_x$

RF

Detection

No diffusion gradient is applied to the gradient coil

FIG. 5

```
┌─────────────────────────────────────────────────┐
│   ┌───────────────────────────────────────────┐ │
│   │        Signal Acquisition Module 10        │ │
│   └───────────────────────────────────────────┘ │
│   ┌───────────────────────────────────────────┐ │
│   │     Coefficient Determination Module 11    │ │
│   └───────────────────────────────────────────┘ │
│   ┌───────────────────────────────────────────┐ │
│   │ Compensation Factor Determination Module 12│ │
│   └───────────────────────────────────────────┘ │
│                                                   │
│    Device For Determining Magnetic Resonance      │
│    Gradient Correction Compensation Factor        │
└─────────────────────────────────────────────────┘
```

FIG. 6

```
┌─────────────────────────────────────────────────┐
│   ┌───────────────────────────────────────────┐ │
│   │        Signal Acquisition Module 10        │ │
│   └───────────────────────────────────────────┘ │
│   ┌───────────────────────────────────────────┐ │
│   │     Coefficient Determination Module 11    │ │
│   └───────────────────────────────────────────┘ │
│   ┌───────────────────────────────────────────┐ │
│   │ Compensation Factor Determination Module 12│ │
│   └───────────────────────────────────────────┘ │
│   ┌───────────────────────────────────────────┐ │
│   │          Correction Module 13              │ │
│   └───────────────────────────────────────────┘ │
│                                                   │
│    Magnetic Resonance Gradient Correction Device  │
└─────────────────────────────────────────────────┘
```

FIG. 7

## INTERNATIONAL SEARCH REPORT

| International application No. |
| --- |
| **PCT/CN2023/081635** |

**A.   CLASSIFICATION OF SUBJECT MATTER**

G01R33/565(2006.01)i

According to International Patent Classification (IPC) or to both national classification and IPC

**B.    FIELDS SEARCHED**

Minimum documentation searched (classification system followed by classification symbols)

IPC: G01R

Documentation searched other than minimum documentation to the extent that such documents are included in the fields searched

Electronic data base consulted during the international search (name of data base and, where practicable, search terms used)

CNTXT, ENTXTC, VEN, DWPI: 线圈, 弥散, 扩散, 梯度, 校正, 固有, 各向同性, coils, diffusion, gradient, isotropic

**C.    DOCUMENTS CONSIDERED TO BE RELEVANT**

| Category* | Citation of document, with indication, where appropriate, of the relevant passages | Relevant to claim No. |
| --- | --- | --- |
| PX | CN 114675221 A (WUHAN UNITED IMAGING LIFE SCIENCE INSTRUMENT CO., LTD.) 28 June 2022 (2022-06-28)<br>    description, paragraphs 55-157 | 1-20 |
| A | CN 112272535 A (SHANGHAI UNITED IMAGING HEALTHCARE TECHNOLOGY CO., LTD.) 26 January 2021 (2021-01-26)<br>    description, paragraphs 72-89 | 1-20 |
| A | CN 102038502 A (SIEMENS AG) 04 May 2011 (2011-05-04)<br>    entire document | 1-20 |
| A | CN 103505212 A (SAMSUNG ELECTRONICS CO., LTD. et al.) 15 January 2014 (2014-01-15)<br>    entire document | 1-20 |
| A | CN 104379058 A (DUKE UNIVERSITY) 25 February 2015 (2015-02-25)<br>    entire document | 1-20 |
| A | CN 1711481 A (KONINKL PHILIPS ELECTRONICS N.V.) 21 December 2005 (2005-12-21)<br>    entire document | 1-20 |

☑ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **28 June 2023** | **02 July 2023** |

| Name and mailing address of the ISA/CN | Authorized officer |
| --- | --- |
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2023/081635**

## C.    DOCUMENTS CONSIDERED TO BE RELEVANT

| Category* | Citation of document, with indication, where appropriate, of the relevant passages | Relevant to claim No. |
|---|---|---|
| A | JP 2018196582 A (HITACHI LTD.) 13 December 2018 (2018-12-13)<br>entire document | 1-20 |
| A | US 2011187367 A1 (FEIWEIER, T. et al.) 04 August 2011 (2011-08-04)<br>entire document | 1-20 |
| A | US 2012025825 A1 (PORTER, D. A.) 02 February 2012 (2012-02-02)<br>entire document | 1-20 |
| A | US 2015137813 A1 (THE REGENTS OF THE UNIVERSITY OF MICHIGAN) 21 May 2015<br>(2015-05-21)<br>entire document | 1-20 |
| A | US 2018049665 A1 (UNIVERSITY OF UTAH RESEARCH FOUNDATION) 22 February<br>2018 (2018-02-22)<br>entire document | 1-20 |
| A | US 2020379072 A1 (US HEALTH) 03 December 2020 (2020-12-03)<br>entire document | 1-20 |
| A | US 5539310 A (US ARMY) 23 July 1996 (1996-07-23)<br>entire document | 1-20 |
| A | US 2014266195 A1 (LEVIN, P.) 18 September 2014 (2014-09-18)<br>entire document | 1-20 |
| A | US 2019004137 A1 (HARRIS, C. T. et al.) 03 January 2019 (2019-01-03)<br>entire document | 1-20 |

Form PCT/ISA/210 (second sheet) (July 2022)

**INTERNATIONAL SEARCH REPORT**
Information on patent family members

International application No.

**PCT/CN2023/081635**

| Patent document cited in search report | | | Publication date (day/month/year) | Patent family member(s) | | | Publication date (day/month/year) |
|---|---|---|---|---|---|---|---|
| CN | 114675221 | A | 28 June 2022 | None | | | |
| CN | 112272535 | A | 26 January 2021 | None | | | |
| CN | 102038502 | A | 04 May 2011 | DE | 102009049402 | A1 | 05 May 2011 |
| | | | | DE | 102009049402 | B4 | 27 September 2012 |
| | | | | US | 2011085722 | A1 | 14 April 2011 |
| | | | | US | 8503752 | B2 | 06 August 2013 |
| CN | 103505212 | A | 15 January 2014 | KR | 101301490 | B1 | 29 August 2013 |
| | | | | US | 2013335080 | A1 | 19 December 2013 |
| | | | | US | 10145923 | B2 | 04 December 2018 |
| | | | | EP | 2677334 | A1 | 25 December 2013 |
| CN | 104379058 | A | 25 February 2015 | WO | 2014004870 | A1 | 03 January 2014 |
| | | | | US | 2014002078 | A1 | 02 January 2014 |
| | | | | US | 9760979 | B2 | 12 September 2017 |
| | | | | EP | 2858559 | A1 | 15 April 2015 |
| | | | | EP | 2858559 | A4 | 29 June 2016 |
| | | | | EP | 2858559 | B1 | 20 January 2021 |
| | | | | US | 2015154741 | A1 | 04 June 2015 |
| | | | | US | 9886745 | B2 | 06 February 2018 |
| CN | 1711481 | A | 21 December 2005 | US | 2006001424 | A1 | 05 January 2006 |
| | | | | US | 7057388 | B2 | 06 June 2006 |
| | | | | AU | 2003272024 | A1 | 15 June 2004 |
| | | | | JP | 2006506154 | A | 23 February 2006 |
| | | | | JP | 4460457 | B2 | 12 May 2010 |
| | | | | EP | 1585991 | A1 | 19 October 2005 |
| | | | | EP | 1585991 | B1 | 21 November 2007 |
| | | | | DE | 60317716 | D1 | 03 January 2008 |
| | | | | DE | 60317716 | T2 | 30 October 2008 |
| | | | | WO | 2004046746 | A1 | 03 June 2004 |
| JP | 2018196582 | A | 13 December 2018 | JP | 6843706 | B2 | 17 March 2021 |
| US | 2011187367 | A1 | 04 August 2011 | US | 8508226 | B2 | 13 August 2013 |
| | | | | DE | 102010001577 | A1 | 22 September 2011 |
| | | | | DE | 102010001577 | B4 | 08 March 2012 |
| US | 2012025825 | A1 | 02 February 2012 | DE | 102010038775 | A1 | 02 February 2012 |
| | | | | DE | 102010038775 | B4 | 31 October 2012 |
| | | | | US | 8729897 | B2 | 20 May 2014 |
| US | 2015137813 | A1 | 21 May 2015 | WO | 2013166416 | A1 | 07 November 2013 |
| | | | | US | 9851426 | B2 | 26 December 2017 |
| | | | | EP | 2845023 | A1 | 11 March 2015 |
| US | 2018049665 | A1 | 22 February 2018 | US | 10959642 | B2 | 30 March 2021 |
| US | 2020379072 | A1 | 03 December 2020 | WO | 2018187764 | A1 | 11 October 2018 |
| US | 5539310 | A | 23 July 1996 | AU | 7554894 | A | 28 February 1995 |
| | | | | WO | 9504940 | A1 | 16 February 1995 |
| US | 2014266195 | A1 | 18 September 2014 | US | 9513358 | B2 | 06 December 2016 |
| | | | | WO | 2014164963 | A1 | 09 October 2014 |
| US | 2019004137 | A1 | 03 January 2019 | DE | 102018115409 | A1 | 03 January 2019 |
| | | | | CA | 3009926 | A1 | 28 December 2018 |
| | | | | US | 10545211 | B2 | 28 January 2020 |
| | | | | GB | 201810426 | D0 | 08 August 2018 |

Form PCT/ISA/210 (patent family annex) (July 2022)

**INTERNATIONAL SEARCH REPORT**
Information on patent family members

International application No.

**PCT/CN2023/081635**

| Patent document cited in search report | Publication date (day/month/year) | Patent family member(s) | | Publication date (day/month/year) |
|---|---|---|---|---|
| | | GB | 2565893 A | 27 February 2019 |
| | | GB | 2565893 B | 23 March 2022 |
| | | JP | 2019005586 A | 17 January 2019 |
| | | JP | 7184479 B2 | 06 December 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210253003